# EUROPÄISCHE PATENTANMELDUNG

(11) **EP 1 826 827 A2**
(43) Veröffentlichungstag der Anmeldung: **29.08.2007**
(21) Anmeldenummer: 07002147.2
(22) Anmeldetag: 01.02.2007
(51) Int. Cl.: H01L 31/048

(54) **Aus Kunststoff gespritzte Formgehäuse zur Aufnahme von elektrischen und/oder elektronischen Einbauteilen oder Einbaugeräten**

(30) Priorität: 23.02.2006 DE 102006009002
(71) Anmelder: Erwin Quarder Systemtechnik GmbH, 32339 Espelkamp (DE)
(72) Erfinder: Koshmehl, Ralf, 32423 Minden (DE)
(74) Vertreter: Lange, Gerd

(57) **Zusammenfassung**

Die Erfindung betrifft aus Kunststoff gespritzte Formgehäuse mit formstabilen Wandungen zur Aufnahme von elektrischen und/oder elektronischen Einbauteilen oder Einbaugeräten, und es wird vorgeschlagen, daß das Formgehäuse für die Einbauteile oder Einbaugeräte eine eigene integrierte Stromerzeugung zur Verfügung stellt derart, daß die formstabilen Wandungen des Formgehäuses zumindest in Teilbereichen als formstabile Träger für flexible Dünnschicht-Solarzellen dienen.

## Beschreibung

Die Erfindung betrifft aus Kunststoff gespritzte Formgehäuse mit formstabilen Wandungen zur Aufnahme von elektrischen und/oder elektronischen Einbauteilen oder Einbaugeräten.

Formgehäuse der vorgenannten Art werden bevorzugt aus einem Kunststoff mit einer harten, gegen mechanische und chemische Beschädigungen unempfindlichen Oberfläche hergestellt, wie z.B. Formgehäuse für Handies oder sonstige Formgehäuse der Unterhaltungselektronik. Auch technische Formgehäuse, die z. B. im industriellen Bereich für den Einbau von elektrischen und/oder elektronischen Funktionseinheiten dienen, müssen mit hoher Zuverlässigkeit die Einbauteile gegen mechanische Beschädigungen und z.B. auch vor Oxidation schützen. Für diese Zwecke ist es bekannt, den Einbau der elektrischen und/oder elektronischen Bauteile oder Geräte in die Formgehäuse dadurch zu optimieren und zu vereinfachen, daß man die Wandungen der Formgehäuse als Schutzeinrichtung für elektrische Leitungen verwendet und bereits bei der Herstellung der Kunststoffgehäuse die benötigten elektrischen Zu- und Ableitungen für die elektrische Stromversorgung der Einbauteile oder des Einbaugerätes in die Wandungen des Formgehäuses mit einspritzt oder in Form einer flexiblen Leiterbahnfolie auf die innere Oberfläche der Wandungen der Formgehäuse aufbringt (vergl. hierzu DE 196 09 253 C2 und EP 1 231 824 A2).

Aufgabe der vorliegenden Erfindung ist es, die elektrische Stromversorgung für die elektrischen und/oder elektronischen Bauteile oder Geräte, die in solche aus Kunststoff gespritzten Formgehäuse eingebaut werden, zu verbessern.

Diese Aufgabe wird erfindungsgemäß dadurch gelöst, daß das Formgehäuse selbst, d.h. mittels einer integrierten Stromerzeugung die Stromversorgung für die Einbauteile oder Einbaugeräte zur Verfügung stellt derart, daß die außen liegenden Wandungen des Formgehäuses zumindest in Teilbereichen als formstabile Träger für flexible, auf einer Folie abgeschiedener und verschalteter Dünnschicht-Solarzellen dienen, wobei die Dünnschicht-Solarzellen der jeweiligen Formgebung der Träger-Wandung vollflächig folgen und mit der Träger-Wandung mechanisch oder physikalisch-chemisch verbunden sind.

Ein sehr kostengünstiges Herstellungsverfahren für ein erfindungsgemäßes Formgehäuse ist dann möglich, wenn gemäß Anspruch 2 der vorliegenden Anmeldung die Dünnschicht-Solarzellen auf der äußeren, dem Benutzer des Fromgehäuses zugewandten Oberfläche der Träger-Wandungen positioniert sind, da in diesem Fall die Folie (meist eine Kunststoff- oder Metallfolie) mit dem auf der Folie galvanisch abgeschiedenen Dünnschicht-Solarzellen in das offene Kunststoff-Spritzwerkzeug eingelegt und mit Kunststoff hinterspritzt werden kann. Beim Hinterspritzen können elektrische Endkontakte der ansonsten bereits auf der Folie elektrisch in Serie verschalteten Dünnschicht-Solarzellen freigelassen werden, so daß ausgehend von dem Innenraum des Formgehäuses eine elektrische Verbindung zwischen den Dünnschicht-Solarzellen und den eingebauten elektrischen und/oder elektronischen Bauteilen oder Geräten problemlos hergestellt werden kann.

Alternativ können die elektrischen Verbindungen zu den Dünnschicht-Solarzellen auch mittels vom Innenraum des Formgehäuses zugänglicher Preßpins, Lötkontakte oder Klemmkontakte herstellt werden.

Die Fixierung der Dünnschicht-Solarzellen auf der äußeren, dem Benutzer des Formgehäuses zugewandten Oberfläche der formstabilen Träger-Wandungen kann beim Hinterspritz-Vorgang mechanisch durch Verkrallungen und/oder bei geeigneten Materialien auch physikalisch-chemisch durch Verklebung der Träger-Wandung des Formgehäuses mit der Folie der Dünnschicht-Solarzellen erfolgen.

Bei dieser Ausführungsform der Erfindung, bei der die Dünnschicht-Solarzellen auf der äußeren, dem Benutzer des Formgehäuses zugewandten Oberfläche der Träger-Wandungen auf gebracht sind, ist es zu empfehlen, eine zusätzliche Schutzfolie oder eine sonstige lichtdurchlässige Schutzschicht auf die Dünnschicht-Solarzellen aufzubringen, um Verkratzungen oder sonstige ungewollte mechanische Beschädigungen der Dünnschicht-Solarzellen zu vermeiden.

Eine weitere Ausführungsform der Erfindung sieht gemäß Anspruch 3 vor, daß die Dünnschicht-Solarzellen auf der inneren Oberfläche der Träger-Wandungen des Formgehäuses aufgebracht sind, wobei die Träger-Wandungen in diesem Bereich lichtdurchlässig sein müssen und zwar zumindest für die Wellenlängen des Lichtes, die von den Solarzellen erfaßt werden.

Auch hier gilt, daß die formstabilen Wandungen des Formgehäuses als tragende Struktur für die flexiblen Dünnschicht-solarzellen dienen. Die flexiblen Dünnschicht-Solarzellen liegen vollflächig an der inneren Oberfläche der Träger-Wandungen an und folgen deren Formgebungen uneingeschränkt. Sie werden vorzugsweise mit der inneren Oberfläche der Träger-Wandungen physikalisch-chemisch verklebt, gegebenenfalls auch unter Zugabe eines lichtdurchlässigen Klebstoffes.

Bei der Fixierung der flexiblen Dünnschicht-Solarzellen auf der inneren Oberfläche der Träger-Wandungen können Randbereiche der Dünnschicht-Solarzellen un-fixiert bleiben, so daß diese Randbereiche infolge ihrer Flexibilität bei der Montage der Einbauteile oder Einbaugeräte in das Formgehäuse an diese herangeführt werden können und eine direkte elektrische Verbindung zu den Einbauteilen oder Einbaugeräten ermöglichen.

Eine weitere vorteilhafte Ausführungsform der Erfindung ist gemäß Anspruch 4 dadurch zu erreichen, daß die Bereiche der Träger-Wandungen, die als formstabile Träger-Wandungen für die flexiblen Dünnschicht-Solarzellen dienen sollen, zweischalig gespritzt werden. In einem ersten Schuß wird die äußere Schale der Träger-wandung aus einem lichtdurchlässigen Kunststoff gespritzt, woraufhin die Dünnschicht-Solarzellen auf die innere Oberfläche der äußeren Schale aufgebracht und erforderlichenfalls lage-fixiert werden. Sodann erfolgt in einem zweiten Schuß das Spritzen der inneren Schale, wobei Lochbereiche in der Folie der Dünnschicht-Solarzellen "durchspritzt" werden können, so daß die Dünnschicht-Solarzellen mechanisch zwischen der äußeren und der inneren Schale der Träger-Wandungen des Formgehäuses fixiert sind und infolge ihrer Positionierung zwischen den beiden Schalen des Formgehäuses sehr gut gegen Beschädigungen aller Art geschützt sind.

## Patentansprüche

1. Aus Kunststoff gespritzte Formgehäuse mit formstabilen Wandungen zur Aufnahme von elektrischen und/oder elektronischen Einbauteilen oder Einbaugeräten,
**dadurch gekennzeichnet,**
- **daß** das Formgehäuse für die Einbauteile oder Einbaugeräte eine eigene integrierte Stromerzeugung zur Verfügung stellt derart,
- **daß** die außen liegenden, dem Benutzer des Formgehäuses zugewandten Wandungen des Formgehäuses zumindest in Teilbereichen als formstabile Träger für flexible, auf einer Folie angeordneter und elektrisch in Serie verschalteter Dünnschicht-Solarzellen dienen,
- wobei die Dünnschicht-Solarzellen der jeweiligen Formgebung der Träger-Wandung folgen und mit der Träger-Wandung mechanisch oder physikalisch-chemisch verbunden sind.

2. Formgehäuse nach Anspruch 1,
**dadurch gekennzeichnet,**
- **daß** die Dünnschicht-Solarzellen auf der äußeren, dem Benutzer der Formgehäuse zugewandten Oberfläche der Träger-Wandungen des Formgehäuses aufgebracht sind.

3. Formgehäuse nach Anspruch 1,
**dadurch gekennzeichnet,**
- **daß** die Dünnschicht-Solarzellen auf der inneren, dem Innenraum des Formgehäuses zugewandten Oberfläche der Träger-Wandungen des Formgehäuses aufgebracht sind
- und die Träger-Wandungen in diesen Bereichen lichtdurchlässig sind.

4. Formgehäuse nach Anspruch 1,
**dadurch gekennzeichnet,**
- **daß** die Träger-Wandungen der Formgehäuse zumindest in den Bereichen der Anordnung der Dünnschicht-Solarzellen zweischalig hergestellt sind
- wobei die äußeren Schalen der Träger-Wandungen lichtdurchlässig sind,
- und die Dünnschicht-Solarzellen zwischen der äußeren und der inneren Schale der Träger-Wandungen eingebettet sind.
